# EUROPÄISCHE PATENTSCHRIFT

(11) **EP 1 163 727 B1**
(45) Veröffentlichungstag und Bekanntmachung des Hinweises auf die Patenterteilung: **13.11.2002**
(21) Anmeldenummer: 00920401.7
(22) Anmeldetag: 21.03.2000
(51) Int. Cl.: H03L 7/23

(54) **FREQUENZSYNTHESIZER**
FREQUENCY SYNTHESISER
SYNTHETISEUR DE FREQUENCE

(30) Priorität: 23.03.1999 DE 19913110
(43) Veröffentlichungstag der Anmeldung: 19.12.2001
(73) Patentinhaber: Infineon Technologies AG, 81669 München (DE)
(72) Erfinder: HEYMANN, Roland, D-82054 Sauerlach (DE)
(74) Vertreter: Epping Hermann & Fischer
(86) Internationale Anmeldenummer: DE0000873
(87) Internationale Veröffentlichungsnummer: WO00057555

(56) Entgegenhaltungen:
- EP-A- 0 585 050
- WO-A-98/42076
- US-A- 4 180 783
- US-A- 5 479 458
- STIRLING R C: "FREQUENCY SYNTHESIZERS FOR TELEMETRY RECEIVERS" MICROWAVE JOURNAL., Bd. 33, Nr. 7, 1. Juli 1990 (1990-07-01), Seiten 99,102-104, XP000149055 HORIZON HOUSE. DEDHAM., US ISSN: 0192-6225

## Beschreibung

Die vorliegende Erfindung betrifft einen Frequenzsynthesizer, insbesondere einen Frequenzsynthesizer zur Erzeugung von Mischoszillatorsignalen beispielsweise für einen I/Q-Mischer eines Homodyn-Breitbandempfängers.

Bekannterweise werden in digitalen Empfangssystemen Frequenzsynthesizer in Form von Mischoszillatoren zur Erzeugung von 0°/90°-Mischoszillatorsignalen verwendet, wobei die 0°/90°-Mischoszillatorsignale einem Mischer zugeführt werden, um dort mit den Hochfrequenz-Empfangssignalen des Empfängers zur Erzeugung von I/Q-Komponentensignalen gemischt zu werden. Dabei bezeichnet I die Signalkomponente, welche in Phase zur Trägerphase liegt, während Q die Quadraturkomponente senkrecht zur Trägerphase bezeichnet.

Bei bekannten Empfangssystemen wird das 0°/90°-Mischoszillatorsignal mit Hilfe eines herkömmlichen Phasenregelkreises (Phase Locked Loop, PLL) erzeugt, wobei die Schleife des Phasenregelkreises im wesentlichen einen Referenzoszillator, einen Phasendetektor, einen spannungsgesteuerten Oszillator und einen Frequenzteiler aufweist. Der Phasendetektor vergleicht die Frequenz des von dem Referenzoszillator gelieferten Referenzsignals mit der Ausgangsfrequenz des im Rückkopplungszweig der Schleife befindlichen Frequenzteilers und steuert abhängig von dem Vergleichsergebnis den spannungsgesteuerten Oszillator an, um somit das Mischoszillatorsignal mit der gewünschten Frequenz zu erzeugen.

Alle bekannten Empfangssysteme arbeiten mit einem Mischoszillator auf der Empfangsfrequenz des Empfängers. Dies hat zur Folge, daß in dem Empfänger relativ starke Oszillatorpulling-Effekte auftreten können, welche in dem Mischoszillatorsignal Frequenzfehler hervorrufen. Ein weiteres typisches Problem bekannter Empfangssysteme betrifft die Eigenmischung des Mischoszillators, welche durch Übersprechen auf den Hochfrequenzeingang des entsprechenden Empfängers hervorgerufen wird und Offset-Gleichspannungen zur Folge hat, die zu einer Übersteuerung der in dem Empfänger verwendeten Verstärker führen können. Darüber hinaus weisen zweikanalige digitale I/Q-Homodynempfangssysteme eine relativ schlechte Signalperformance auf. Bei bekannten Lösungen ohne Frequenzbandaufteilung kann ein großer Abstimm- oder Verstimmbereich des spannungsgesteuerten Oszillators nicht gleichzeitig mit guter Signalperformance abgedeckt werden. Eine Aufteilung des Frequenzbands ist bei herkömmlichen Empfangssystemen meistens nicht bzw. - falls doch - nur unter Verwendung von mehreren Oszillatoren vorgesehen. Die ausschließlich verwendeten analogen Methoden zur Erzeugung der für I/Q-Empfangssysteme notwendigen 0°/90°-Mischoszillatorsignale bieten nicht die Genauigkeit und Stabilität digitaler Methoden, so daß eine erhöhte Fertigungsstreuempfindlichkeit zu erwarten ist, die wiederum erhöhte Testkosten zur Folge hat.

In der EP-A2-0 585 050 ist ein Frequenzsynthesizer mit verringertem Jitter gezeigt, er umfaßt einen ersten Phasenregelkreis, dessen VCO ausgangsseitig ein zweiter Phasenregelkreis kaskadiert nachgeschaltet ist. Das Ausgangssignals des VCOs des zweiten Phasenregelkreises bildet einerseits das Ausgangssignals des Frequenzsynthesizers und wird andererseits über jeweilige Teiler auf die Phasendetektoren des ersten und zweiten Phasenregelkreises zurückgekoppelt. In der DE-A1-43 29 353 ist ein weiteres PLL-System mit kaskadierten Phasenregelkreisen gezeigt. Das Ausgangssignal wird am Ausgang des VCOs des zweiten Phasenregelkreises abgegriffen.

Der vorliegenden Erfindung liegt daher die Aufgabe zugrunde, einen Frequenzsynthesizer zu schaffen, der durch relativ einfache schaltungstechnische Mittel einen breiten Hochfrequenz-Abstimmbereich des darin verwendeten spannungsgesteuerten Oszillators ermöglicht. Insbesondere soll der Frequenzsynthesizer zur Verwendung als Mischoszillator in einem digitalen Homodynempfangssystem geeignet sein, wobei in diesem Fall die oben beschriebenen und mit herkömmlichen Mischoszillatorlösungen verbundenen Probleme, wie z.B. Oszillatorpulling oder Eigenmischung, beseitigt sind.

Diese Aufgabe wird gemäß der vorliegenden Erfindung durch einen Frequenzsynthesizer mit den Merkmalen des Anspruches 1 gelöst. Die Unteransprüche haben bevorzugte und vorteilhafte Ausführungsformen der Erfindung zum Gegenstand.

Ein erster Phasenregelkreis ist um einen weiteren Phasenregelkreis erweitert, welcher kaskadenartig mit dem bekannten Phasenregelkreis verschaltet ist, so daß der zweite Phasenregelkreis in der Rückkopplungsschleife des ersten Phasenregelkreises zwischen dessen spannungsgesteuerten Oszillator und dessen Frequenzteiler vorgesehen ist. Es sind somit zwei ineinander verschachtelte Phasenregelkreise vorgesehen.

Auf diese Weise kann der spannungsgesteuerte Oszillator des ersten Phasenregelkreises des Frequenzsynthesizers auf von der Empfangsfrequenz des entsprechenden Empfängers abweichende Frequenzen gelegt werden und arbeitet somit bezüglich der Empfangsfrequenz auf einem Frequenzoffset, um Oszillatorpulling- und Eigenmischungseffekte zu vermeiden. Auch die anderen Oszillatoren des Frequenzsynthesizers schwingen nicht auf der Empfangsfrequenz.

Vorzugsweise arbeitet der zweite Phasenregelkreis auf der vierfachen Empfangsfrequenz, so daß eine digitale Erzeugung des 0°/90°-Mischoszillatorsignals für digitale Empfangssysteme mit äußerst hoher Genauigkeit (Abweichung < 1°) und unabhängig von Fertigungstoleranzen ermöglicht wird, da das 0°/90°-Mischoszillatorsignal beispielsweise durch einen hochgenauen Johnson-Zähler erzeugt werden kann, der mit Ausnahme des eingebauten Matching kaum weiteren Fertigungstoleranzen unterliegt.

Die vorliegende Erfindung bietet die Möglichkeit, den Empfangsbereich in Bänder aufzuteilen, ohne daß hierzu mehrere Oszillatoren benötigt werden, so daß ein Frequenzsynthesizer mit einem breiten Abstimmbereich und mit hoher Güte bei geringer Variation des Phasenrauschens, welches bei Digitalsystemen einen entscheidenden Betriebsparameter für die Systemperformance darstellt, realisiert werden kann.

Besonders vorteilhaft ist es, wenn der Frequenzsynthesizer programmierbar ausgestaltet wird, was der Flexibilität und somit der Kundenfreundlichkeit zugute kommt. Obwohl der spannungsgesteuerte Oszillator des ersten Phasenregelkreises nicht auf der Empfangsfrequenz schwingt, wird als Referenzfrequenz für den ersten Phasenregelkreis dennoch die Empfangsfrequenz, d.h. die Oszillatorfrequenz des Mischers des Empfängers, gewählt, so daß der Phasenregelkreis einfacher programmiert werden kann, da er genau auf die Abstimmfrequenzen eingestellt wird. Ein weiterer großer Vorteil ist, daß die Schrittweite des Phasenregelkreises bezüglich der Empfangsfrequenz erhalten wird.

Die oben genannten Vorteile wären bei bekannten Frequenzsynthesizern, die auf dem eingangs beschriebenen herkömmlichen PLL-Abstimmprinzip beruhen, unter der Voraussetzung, daß der spannungsgesteuerte Oszillator nicht auf der Empfangsfrequenz arbeiten soll, nicht möglich.

Die Erfindung wird nachfolgend unter Bezugnahme auf die beigefügte Zeichnung anhand bevorzugter Ausführungsbeispiele, welche die bevorzugte Verwendung der vorliegenden Erfindung als Mischoszillator, insbesondere als 0°/90°-Mischoszillator, in einem Homodynempfänger betreffen, erläutert. Es wird jedoch ausdrücklich darauf hingewiesen, daß die Erfindung nicht auf diesen Verwendungsbereich beschränkt ist, sondern prinzipiell beliebig in jedem analogen oder digitalen System eingesetzt werden kann, wo das Bedürfnis nach einem hochgenauen Frequenzsynthesizer mit einem breiten Abstimmbereich besteht.
Fig. 1 zeigt ein vereinfachtes Blockschaltbild eines ersten Ausführungsbeispiels der vorliegenden Erfindung,
Fig. 2 zeigt ein vereinfachtes Blockschaltbild eines zweiten Ausführungsbeispiels der vorliegenden Erfindung,
Fig. 3 zeigt die Anbindung eines erfindungsgemäßen Frequenzsynthesizers an einen I/Q-Mischer in einem Homodynempfangssystem,
Fig. 4 zeigt eine Tabelle zur Erläuterung von bei den in Fig. 1 und Fig. 2 gezeigten Ausführungsbeispielen programmierbaren Abstimmbereichen des spannungsgesteuerten Oszillators des ersten Phasenregelkreises, und
Fig. 5, 6 und 7 zeigen je ein Diagramm von Empfangsfrequenz und Frequenz des VCO des ersten Phasenregelkreises für verschiedene Verhältnisse von R₂/N₂.

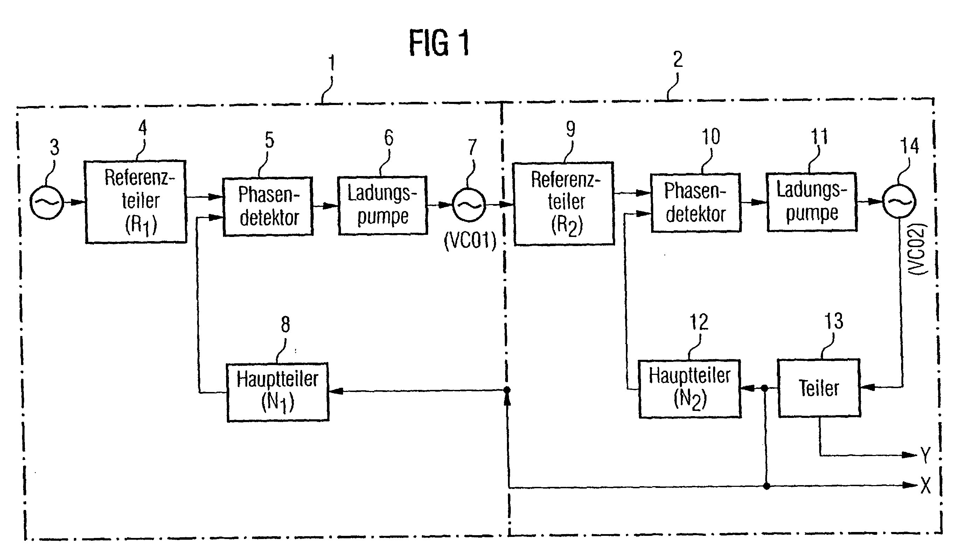

Das in Fig.1 gezeigte Ausführungsbeispiel umfaßt im wesentlichen zwei verschachtelte Phasenregelkreise (PLL) 1 und 2, d.h. der üblicherweise in Abstimmsystemen verwendete erste Phasenregelkreis 1 wurde um den damit kaskadenartig verschalteten zweiten Phasenregelkreis 2 erweitert.

Der erste Phasenregelkreis 1 umfaßt einen Referenzoszillator 1, einen Referenzteiler 4 zum Teilen der von dem Referenzoszillator gelieferten Frequenz mit einem Teilerverhältnis 1:R₁, einen Phasendetektor 5, eine damit in Serie geschaltete Ladungspumpe 6, einen spannungsgesteuerten Oszillator (Voltage Controlled Oscillator, VCO1) und einen im Rückkopplungspfad des Phasenregelkreises angeordneten weiteren und als Hauptteiler bezeichneten Frequenzteiler 8 mit dem Teilerverhältnis 1:N₁. Der Phasendetektor 5 vergleicht die ihm zugeführten Frequenzen des Referenzteiler 4 und des Hauptteilers 8 und erzeugt abhängig von dem Vergleichsergebnis ein Stellsignal, um über die Ladungspumpe 6 die Ausgangsfrequenz des spannungsgesteuerten Oszillators 7 nachzuregeln.

Üblicherweise ist der Rückkopplungspfad zwischen dem Ausgang des Oszillators 7 und dem Hauptteiler 8 geschlossen. Erfindungsgemäß ist hingegen der zweite Phasenregelkreis 2 in den an dieser Stelle aufgebrochenen Rückkopplungspfad des ersten Phasenregelkreises 1 angeordnet. Auch der zweite Phasenregelkreis 2 umfaßt einen Referenzteiler mit dem Teilerverhältnis 1:R₂, einen Phasendetektor 10, eine Ladungspumpe 11, einen spannungsgesteuerten Oszillator (VCO2) 14 und einen weiteren Frequenzteiler bzw. Hauptteiler 12 mit dem Teilerverhältnis 1:N₂, der auf an sich übliche Art und Weise im Rückkopplungspfad des zweiten Phasenregelkreises 2 angeordnet ist. Der Phasendetektor 10 vergleicht die vom Hauptteiler 12 gelieferte Frequenz mit der vom Referenzteiler 9 gelieferten Frequenz und steuert davon abhängig über die Ladungspumpe 11 den Oszillator 14 an, um dessen Ausgangsfrequenz entsprechend dem Vergleichsergebnis des Phasendetektors 10 nachzuregeln. Die kaskadenartige Verschachtelung der beiden Phasenregelkreise ist somit derart, daß dem Referenzteiler 9 des zweiten Phasenregelkreises 2 als Referenzsignal das Ausgangssignal des spannungsgesteuerten Oszillators 7 des ersten Phasenregelkreises 1 und dem Hauptteiler 8 des ersten Phasenregelkreises 1 ein von dem spannungsgesteuerten Oszillator 14 des zweiten Phasenregelkreises 2 gelieferten Ausgangssignal abhängiges Signal zugeführt wird. Diese Anordnung ermöglicht es, den spannungsgesteuerten Oszillator 7 unabhängig von der erforderlichen Mischoszillatorfrequenz für den Hochfrequenz-Eingangsmischer des damit zu betreibenden Homodynempfängers auf andere Frequenzen zu verlegen. D.h. der Oszillator 7 muß nicht auf der von dem zweiten Phasenregelkreis 2 gelieferten erforderlichen Mischoszillatorfrequenz schwingen.

Dennoch ist der erste Phasenregelkreis vorzugsweise auf die angestrebte Mischoszillatorfrequenz referenziert, d.h. dem Phasendetektor 5 wird die gewünschte Mischoszillatorfrequenz von dem Referenzteiler 4 zugeführt, so daß die Phasenregelkreise 1 und 2 einfach in Abhängigkeit von der Mischoszillatorfrequenz programmiert werden können. Ein weiterer großer Vorteil ist, daß die Schrittweite des somit gebildeten Gesamt-Phasenregelkreises in Bezug auf die der Mischoszillatorfrequenz entsprechende Empfangsfrequenz erhalten wird.

Die zuvor beschriebenen Vorteile sind bei einem herkömmlichen PLL-Abstimmsystem mit Rückführung des Ausgangssignals des Oszillators 7 direkt zu dem Hauptteiler 8 nicht möglich, wenn der Oszillator 7 nicht auf der Empfangsfrequenz schwingen soll, da sich in diesem-Fall bei Schließen der Rückkopplung zwischen dem Oszillator 7 und dem Hauptteiler 8 die Empfangsschrittweiten und Abstimmfrequenzen durch zusätzliche Formeln berechnen und nicht mehr den programmierten Werten des Phasenregelkreises 1 entsprechen, welche dann auf den Oszillator 7 referenziert sind.

Die in Fig. 1 gezeigten Referenzteiler 4 und 9 sowie Ladungspumpen 6 und 11 stellen zwar keine erfindungswesentlichen Elemente dar, erhöhen jedoch die Flexibiltät und Signalperformance der Schaltung.

Die beiden programmierbaren Frequenzteiler 9 und 12 ermöglichen einen programmierbaren Frequenzoffset des spannungsgesteuerten Oszillators 7 in Bezug auf den Hochfrequenz-Eingang des entsprechenden Empfangssystems bei gleichzeitiger Aufteilung des erforderlichen Hochfrequenz-Abstimmbereichs.

In den Rückkopplungspfad des zweiten Phasenregelkreises 2 ist zwischen den Oszillator 14 und den Hauptteiler 12 vorzugsweise zudem ein weiterer Frequenzteiler 13 geschaltet, der auch als Vorteiler bezeichnet wird. Zwischen dem Vorteiler 13 und dem Hauptteiler 12 wird das gewünschte Mischoszillatorsignal x abgegriffen und dem entsprechenden Mischer zugeführt. Der Vorteiler 13 gewährleistet, daß auch der spannungsgesteuerte Oszillator 14 (VCO2) des zweiten Phasenregelkreises 2 nicht auf der Empfangsfrequenz schwingen muß, d.h. keiner der verwendeten Oszillatoren 3, 7 und 14 schwingt auf der Empfangsfrequenz, so daß die beim eingangs beschriebenen Stand der Technik auftretenden unerwünschten Nebeneffekte, wie insbesondere oszillatorpulling, vermieden werden können.

Für digitale Empfangssysteme ist die Erzeugung von 0°/90°-Mischoszillatorsignalen, d.h. von um 90° zueinander phasenversetzten Mischoszillatorsignalen, erforderlich, die zur Gewinnung des I- bzw- Q-Komponentensignals einem I/Q-Mischer zugeführt werden, der die Hochfrequenz-Empfangssignale mit den 0°/90°-Mischoszillatorsignalen mischt.

Zu diesem Zweck arbeitet der zweite Phasenregelkreis bzw. dessen spannungsgesteuerter Oszillator 14 vorzugsweise auf der vierfachen Empfangsfrequenz, und der Vorteiler 13 ist durch einen hochgenauen Johnson-Zähler mit dem Teilerverhältnis 1:4 gebildet, so daß von dem Vorteiler 13 mit hoher Genauigkeit die 0°/90°-Mischoszillatorsignale x und y geliefert werden können. Insbesondere ist in diesem Fall gewährleistet, daß die beiden 0°/90°-Mischoszillatorsignale x und y dasselbe Puls-Pausen-Verhältnis aufweisen, was für eine genaue Erzeugung der I- bzw. Q-Komponentensignale in dem nachgeschalteten Mischer erforderlich ist. Der Johnson-Zähler dient somit in diesem Fall einerseits als Vorteiler für den Oszillator 14 und andererseits als 0°/90°-Spannungsgenerator.

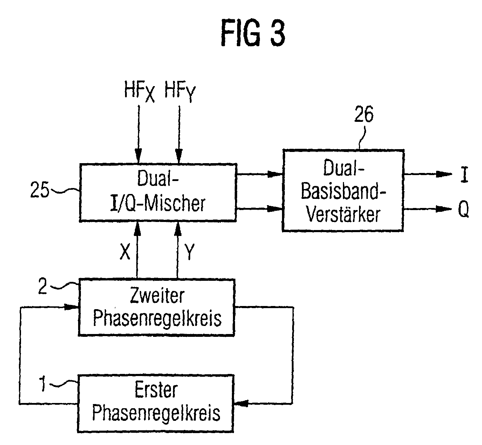

In Fig. 3 ist die bereits zuvor angedeutete Anbindung des erfindungegemäßen Frequenzsynthesizers mit den beiden kaskadenartig verschachtelten Phasenregelkreisen 1 und 2 an einen Dual-I/Q-Mischer 25 eines digitalen Homodynempfängers dargestellt. Von dem in Fig. 1 gezeigten Vorteiler 13 bzw. Johnson-Zähler werden dem Mischer 25 die 0°/90°-Mischoszillatorsignale x, y zugeführt. Des weiteren empfängt der Mischer 25 die Hochfrequenz-Empfangssignale HFx und HFy des Empfangssystems, welche mit einer bestimmten Empfangsfrequenz vorliegen, auf die der erfindungsgemäße Frequenzsynthesizer durch entsprechende Programmierung abgestimmt worden ist, um die mit derselben Frequenz vorliegenden Mischoszillatorsignale x und y zu erzeugen. Der Mischer 25 mischt die Empfangssignale HFx und HFy mit den Mischoszillatorsignalen x bzw. y und führt die daraus resultierenden Signale einem Dual-Basisband-Verstärker 26 zu, der daraufhin die gewünschten I- und Q-Komponentensignale ausgibt.

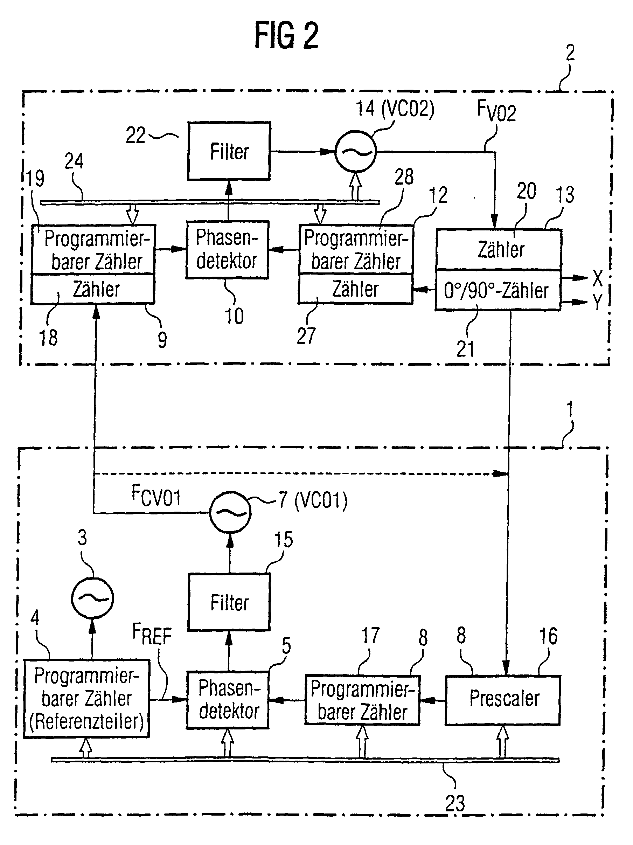

In Fig. 2 ist ein weiteres Ausführungsbeispiel der vorliegenden Erfindung dargestellt, wobei die sich entsprechenden Bauteile mit denselben Bezugszeichen versehen sind. Anstelle der in Fig. 1 gezeigten Ladungspumpen sind gemäß Fig. 2 Tiefpaßfilter 15 bzw. 22 in den Phasenregelkreisen 1 bzw. 2 vorgesehen. Bei dem in Fig. 2 gezeigten Ausführungsbeispiel handelt es sich insbesondere um eine Frequenzsynthesizer oder Mischoszillator für ein digitales Satelliten-Empfangssystem mit einem Empfangsfrequenzbereich von ca. 950-2150 MHz.

Auch aus der Darstellung von Fig. 2 ist die kaskadenartige Verschaltung des zweiten Phasenregelkreises 2, der wie zuvor beschrieben als Quadraturphasengenerator dient und zur Realisierung der Frequenzbandaufteilung des Frequenzoffsets vorgesehen ist, mit dem ersten Phasenregelkreis 1 ersichtlich.

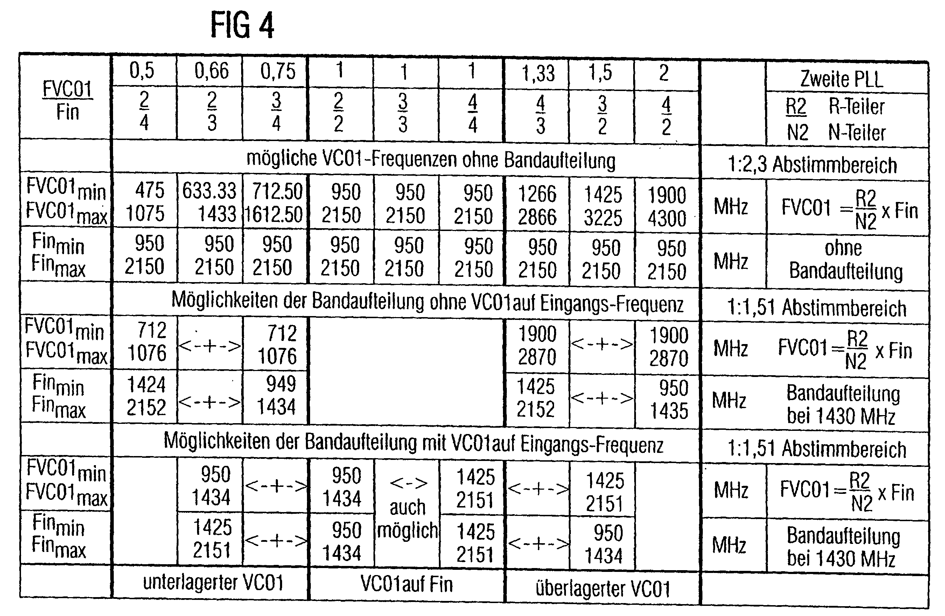

Der Referenzoszillator 3 des ersten Phasenregelkreises 1 besitzt bei diesem Beispiel einen Frequenzbereich von 1 - 16 MHz, und der Referenzteiler 5 ist in Form eines programmierbaren Zählers mit dem Teilerfaktor R1 = 2 - 1023 ausgebildet, so daß an dem Phasendetektor 5 als Referenzfrequenz F_{REF} Schrittweiten von 16 kHz - 2 MHz eingestellt werden. Der in Fig. 1 gezeigte Hauptteiler 8 des ersten Phasenregelkreises 1 ist bei dem in Fig. 2 gezeigten Ausführungsbeispiel durch die Kombination eines Modulus-Prescalers 16 mit einem programmierbaren Zähler 17 gebildet. Der Modulus-Prescaler 16 schaltet zwischen zwei unterschiedlichen Frequenzen um, so daß in Kombination mit dem Zähler 17, der den Teilerfaktor N₁ = 2 - 2023 realisiert, ein lineares Teilen der vom zweiten Phasenregelkreis 2 zugeführten Frequenz möglich ist. Das Filter 15 besitzt vorzugsweise die Grenzfrequenz f_{c} = 2 kHz. Der Frequenzbereich des spannungsgesteuerten Oszillators 7 (VCO1) ist abhängig von dem jeweils gewählten VCO-Bereich aus der noch später diskutierten Fig. 4 ersichtlich (und beträgt beispielsweise 1,9 - 2,9 GHz).

In Fig. 2 ist gestrichelt der Kurzschluß zwischen dem Ausgang des Oszillators 7 und dem Eingang des Prescalers 16 angedeutet, wie er in herkömmlichen PLL-Abstimmsystemen vorgesehen ist.

Erfindungsgemäß ist jedoch diese Verbindung aufgetrennt, und das Ausgangssignal des Oszillators 7 wird dem Referenzteiler 9 des zweiten Phasenregelkreises 2 zugeführt. Wie in dem ersten Phasenregelkreis 1 sind auch in dem zweiten Phasenregelkreis sämliche Teiler durch (programmierbare) Zähler realisiert. Bei diesem Ausführungsbeispiel ist der Referenzteiler durch die Kombination eines Teilers 18 mit dem festen Teilerverhältnis 1:2 und eines programmierbaren Teilers 19 mit dem Teilerverhältnis 1:2, 1:3 oder 1:4 gebildet. Das Filter 22 des zweiten Phasenregelkreises besitzt beispielsweise die Grenzfrequenz f_{c} = 2 MHz. Auch der Hauptteiler 12 des zweiten Phasenregelkreises 2 ist durch die Kombination eines Teilers 27 mit dem festen Teilerverhältnis 1:2 und eines programmierbaren Teilers 28 mit dem Teilerverhältnis 1:2, 1:3 oder 1:4 gebildet. Der Vorteiler 13 ist analog zu Fig. 1 durch einen Johnson-Zähler mit dem festen Teilerverhältnis 1:4 gebildet, Der Johnson-Zähler umfaßt die Kombination eines Zählers 20 mit dem Teilerverhältnis 1:2 und eines 0°/90°-Zählers 21, der ebenfalls das Teilerverhältnis 1:2 realisiert und die 0°/90°-Mischoszillatorsignale x, y bereitstellt. Da der Johnson-Zähler bzw. Vorteiler 13 das feste Teilerverhältnis 1:4 aufweist, werden bei dem in Fig. 2 gezeigten Ausführungsbeispiel zwei spannungsgesteuerte Oszillatoren (VCO2) 14 verwendet, um den gesamten Empfangsfrequenzbereich abdecken zu können, wobei der Frequenzbereich des einen Oszillators F_{VCO2} = 3,4 - 6,2 GHz und der Frequenzbereich des anderen Oszillators F_{VCO2} = 6,0 - 8,6 GHz umfaßt. Wird der Vorteiler 13 programmierbar ausgeführt, ist nur ein spannungsgesteuerter Oszillator 14 nötig. Die Frequenz der 0°/90°-Mischoszillatorsignale x, y entspricht dem Wert F_{VCO1} * N₂/R₂, wobei N₂ den Teilerfaktor des Hauptteilers 12 und R₂ den Teilerfaktor des Referenzteilers 9 bezeichnet.

Die Programmierung der programmierbaren Bauteile des ersten und zweiten Phasenregelkreises 1 und 2 erfolgt über Programmierleitungen 23 und 24, die über eine entsprechende Programmier-Schnittstelle angesteuert werden können. Durch geeignete Programmierung der Phasenregelkreise 1 und 2 wird erreicht, daß die von dem Johnson-Zähler 13 gelieferten 0°/90°-Mischoszillatorsignale x, y den dem Empfangsfrequenzbereich entsprechenden Frequenzbereich 950 - 2150 MHz abdecken. Über die Programmierleitung 24 kann des weiteren zwischen den beiden zuvor erwähnten Oszillatoren 14 des zweiten Phasenregelkreises 2 in Abhängigkeit von der Empfangsfrequenz umgeschaltet werden.

In Fig. 4 ist eine Tabelle zur Erläuterung von bei den in Fig. 1 und Fig. 2 gezeigten Ausführungsbeispielen programmierbaren Abstimmbereichen des spannungsgesteuerten Oszillators 7 des ersten Phasenregelkreises 1 dargestellt. Die Tabelle zeigt die möglichen Frequenzen des Oszillators 7 in Abhängigkeit von dem Verhältnis zur Empfangsfrequenz Fᵢₙ, d.h. in Abhängigkeit von dem Quotienten F_{VCO1}/Fᵢₙ, und dem Teilerverhältnis R₂/N₂. Die Frequenz F_{VCO1} des Oszillators 7 stellt sich stets abhängig von der Empfangsfrequenz Fᵢₙ und dem Ausdruck R₂/N₂ derart ein, daß gilt: F_{VCO1} = Fᵢₙ * R₂/N₂. Insbesondere sind in Fig. 4 die Werte für die Abstimmbereiche 1:2,3 ohne Aufteilung des Frequenzbandes sowie 1:1,51 mit Frequenzbandaufteilung bei 1430 MHz für den Empfangsfrequenzbereich 950 - 2151 MHz dargestellt. Der Fall, daß der Oszillator 7 (VCO1) auf der Empfangsfrequenz Fᵢₙ schwingt, ist zwar grundsätzlich auch möglich, sollte jedoch zur Vermeidung von Oszillatorpulling umgangen werden.

Bei extrem breitbandigen Empfangsbereich wie bei Homodynempfängern wird der Empfangsbreich wie oben beschrieben in mehrere Bänder aufgeteilt. Wird ein einziger VCO zur Abstimmung verwendet, wird das Doppel-PLL-System in der nachfolgend beschriebenen Weise betrieben. Durch verschiedene Teilerverhältnisse R₂/N₂ werden unmittelbar aneinander liegende Frequenzbänder für die Lokaloszillatorfrequenz erzeugt. Der zur Abstimmung dienende Oszillator 7 durchläuft mehrfach seinem Verstimmbereich. Für beispielsweise n verschiedene Teilerverhältnisse R₂/N₂ wird der Empfangsbereich in n Teile aufgeteilt. Deren Größe muß nicht gleich sein, sondern sie hängt von den aneinander angegrenzenden verschiedenen Teilerverhältnissen R₂/N₂ und dem möglichen Verstimmbereich des Oszillators 7 ab. Dabei durchläuft der Oszillator 7 seinen Verstimmbereich n Mal. Die Teiler 4, 8 und deren Teilerverhältnisse R₁/N₁ dienen dabei wie bei einem konventionellen Abstimmungssystems mit einer einzigen PLL zur linearen Programmierung der Lokaloszillatorfrequenzen, die ausgangsseitig am I/Q-Teiler 13 abgreifbar sind. Für Homodynempfänger liegen diese auf der Eingangsfrequenz.

Um die Gefahr von Oszillatorpullingeffekten zu vermeiden, dürfen die Frequenzen des der Abstimmung dienenden Oszillators 7 nicht in der Nähe der Eingangsfrequenz liegen. Hierzu wird das Teilerverhältnis R₂/N₂ genügend weit von eins entfernt gewählt, damit der Oszillator 7 entweder immer außerhalb des Empfangsbereichs liegt oder zumindest soweit entfernt, daß benachbarte Eingangsfrequenzen, die gleich der Frequenz des Oszillators 7 sind, ausreichend unterdrückt werden können. In ersterem Fall eignet sich ein Eingangsfilter mit fixer Durchlaßcharakteristik, in letzterem Fall ein Eingangsfilter mit variablem Durchlaßbereich.

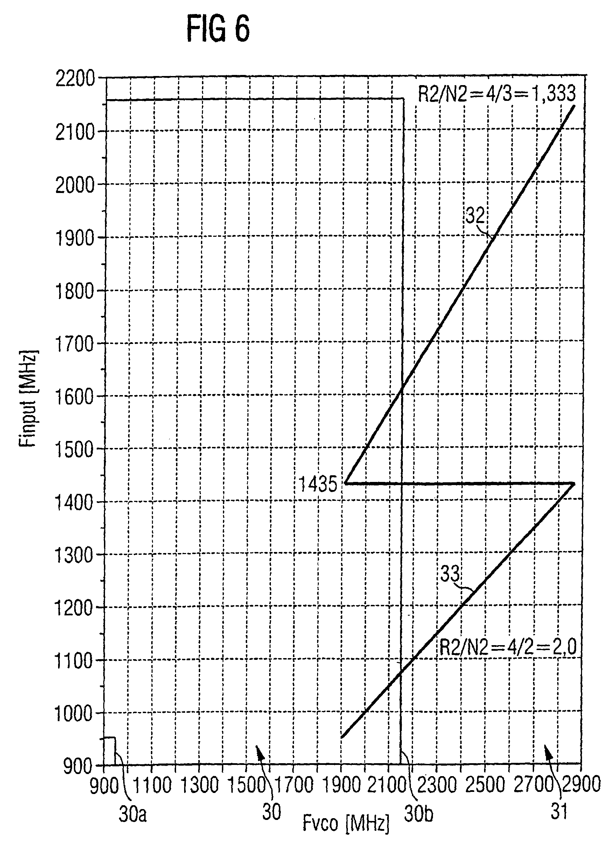

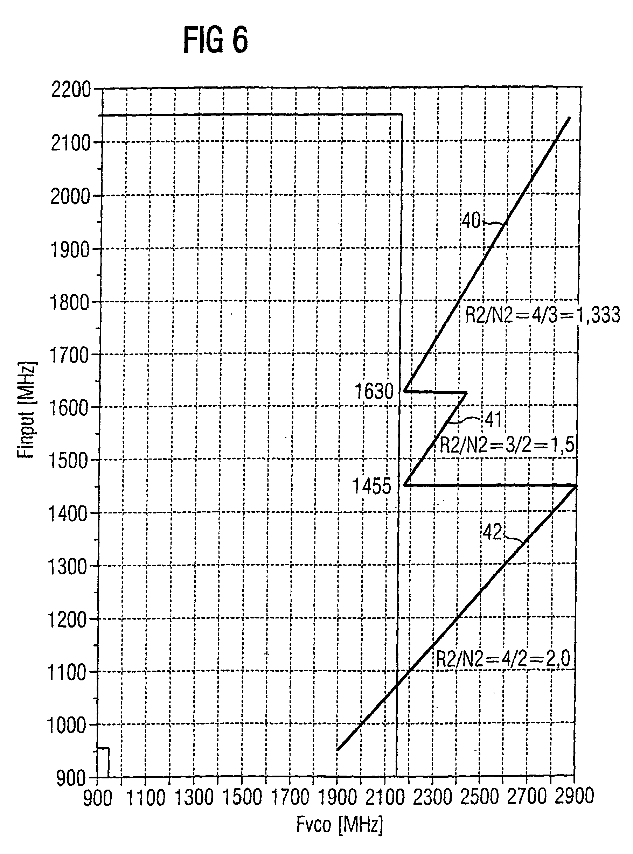

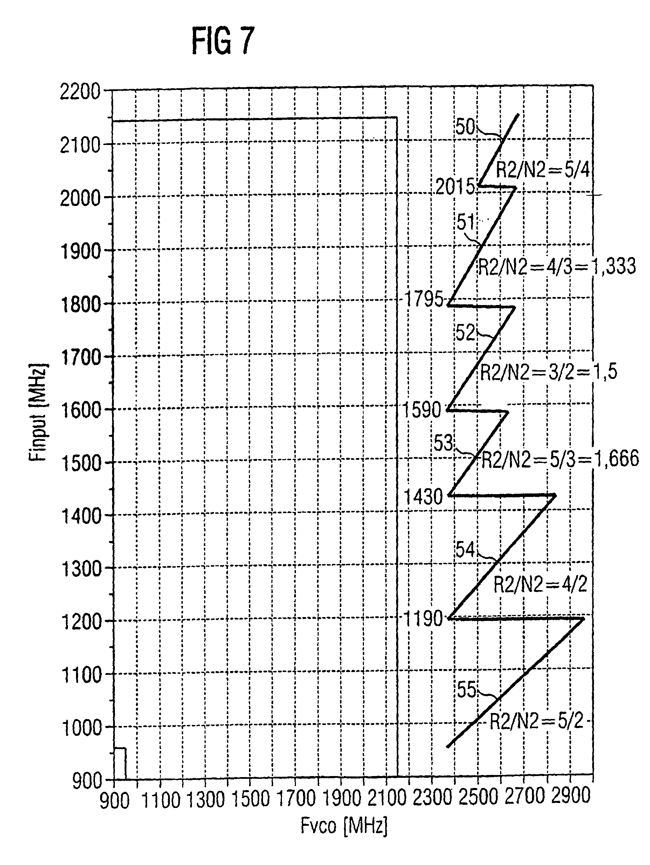

Die in den Figuren 5 bis 7 dargestellten Diagramme zeigen die Lage der Frequenzen des Oszillators 7 relativ zur Eingangsfrequenz für die in den Figuren 1 bzw. 2 beschriebenen Synthesizerschaltungen. In Figur 5 ist durch die Linien 30a und 30b der Empfangsfrequenzbereich 30 markiert. Der Frequenzbereich 31 liegt außerhalb des Empfangsfrequenzbereichs. Die Linien 32, 33 zeigen die Abstimmfrequenzen des Oszillators 7 bei veränderlichem Abstimmbereich, d.h. veränderlichem Teilerverhältnis R₁/N₁. Die Linie 32 zeigt den Verlauf der Frequenz des Oszillators 7 für ein Teilerverhältnis R₂/N₂ = 4/3. Die Abstimmlinie 33 zeigt diesen Verlauf für ein Teilerverhältnis R₂/N₂ = 4/2. Die Linien 32, 33 überschneiden im Bereich ihres niedrigfrequenten Abschnitts noch die Linie 30b, d.h. der Abstimmoszillator 7 schwing bei einigen Empfangsfrequenzen im Empfangsfrequenzbereich für das Eingangssignal. In Figur 6 wird das Teilerverhältnis R₂/N₂ drei Mal geändert, so daß sich drei Empfangsbänder 40, 41 und 42 ergeben. Nur beim Empfangsband 42 liegen Frequenzen des Abstimmoszillators 7 im Eingangsfrequenzbereich. Beim Ausführungsbeispiel der Figur 7 sind sechs Empfangsfrequenzbereiche 50, ...., 55 vorgesehen, die durch entsprechende Teilerverhältnisse R₂/N₂ erzeugt werden. Die Frequenz des Abstimmoszillators 7 liegt ausreichend weit außerhalb des Eingangsempfangsbereichs.

## Patentansprüche

1. Frequenzsynthesizer zur Erzeugung eines Oszillatorsignals (x, y) gewünschter Frequenz,
mit einem ersten Phasenregelkreis (1) zur Erzeugung eines Signals bestimmter Frequenz (F_{VCO1}) aus einem Referenzfrequenzsignal (F_{REF}), einen zweiten Phasenregelkreis (2), der kaskadenartig mit dem ersten Phasenregelkreis (1) verschaltet ist, so daß dem zweiten Phasenregelkreis (2) als eine Referenzfrequenz die Frequenz des von dem ersten Phasenregelkreis erzeugten Signals (F_{VCO1}) zugeführt ist und von dem zweiten Phasenregelkreis (2) das Oszillatorsignal (x, y) mit der gewünschten Frequenz erzeugt wird, wobei der erste Phasenregelkreis (1) eine Referenzspannungsquelle (3) zur Erzeugung des Referenzfrequenzsignals (F_{REF}), einen ersten Phasendetektor (5), einen ersten spannungsgesteuerten Oszillator (7) und einen ersten Frequenzteiler (8) aufweist, wobei der erste Phasendetektor (5) die Frequenz (F_{REF}) des Referenzfrequenzsignals mit einer von dem ersten Frequenzteiler (8) gelieferten Frequenz vergleicht und davon abhängig den ersten spannungsgesteuerten Oszillator (7) ansteuert, wobei der zweite Phasenregelkreis (2) einen zweiten Phasendetektor (10), einen zweiten spannungsgesteuerten Oszillator (14) und einen zweiten Frequenzteiler (12) aufweist, wobei der zweite Phasendetektor (10) eine von dem ersten spannungsgesteuerten Oszillator (7) des ersten Phasenregelkreises (1) gelieferte Frequenz (F_{VCO1}) mit einer von dem zweiten Frequenzteiler (12) gelieferten Frequenz vergleicht und davon abhängig den zweiten spannungsgesteuerten Oszillator (14) ansteuert, wobei ein von dem Ausgangssignal des zweiten spannungsgesteuerten Oszillators (14) abhängiges Signal dem zweiten Frequenzteiler (12) des zweiten Phasenregelkreises (2) und dem ersten Frequenzteiler (8) des ersten Phasenregelkreises (1) zugeführt ist, und wobei die von dem ersten spannungsgesteuerten Oszillator (7) gelieferte Frequenz (F_{VCO1}) über einen vierten Frequenzteiler (9) dem zweiten Phasendetektor (10) des zweiten Phasenregelkreises (2) zugeführt ist,
**dadurch gekennzeichnet,**
**daß** die von dem zweiten spannungsgesteuerten Oszillator (14) des zweiten Phasenregelkreises (2) gelieferte Frequenz (F_{VCO2}) dem zweiten Frequenzteiler (12) des zweiten Phasenregelkreises (2) und dem ersten Frequenzteiler (8) des ersten Phasenregelkreises (1) über einen fünften Frequenzteiler (13) zugeführt ist und das Oszillatorsignal (x, y) von einem Ausgangssignal des fünften Teilers (13) gebildet wird.

2. Frequenzsynthesizer nach Anspruch 1,
**dadurch gekennzeichnet,**
**daß** das von der Referenzspannungsquelle (3) gelieferte Signal über einen dritten Frequenzteiler (4) dem ersten Phasendetektor (5) des ersten Phasenregelkreises (1) zugeführt ist

3. Frequenzsynthesizer nach Anspruch 2,
**dadurch gekennzeichnet,**
**daß** die einzelnen Frequenzteiler (4, 8, 9, 12, 13) jeweils durch Zähler realisiert sind.

4. Frequenzsynthesizer nach Anspruch 2 oder 3,
**dadurch gekennzeichnet,**
**daß** die Frequenz der Referenzspannungsquelle (3) und das Teilerverhältnis (R₁) des im ersten Phasenregelkreis (1) enthaltenen dritten Frequenzteilers (4) derart in Abhängigkeit von der gewünschten Frequenz des Oszillatorsignals (x, y) gewählt sind, daß dem ersten Phasendetektor (5) des ersten Phasenregelkreises (1) als Referenzfrequenz (F_{REF}) die gewünschte Schrittweite des Oszillatorsignals (x, y) zugeführt ist.

5. Frequenzsynthesizer nach einem der Ansprüche 1 bis 4,
**dadurch gekennzeichnet,**
**daß** die Teilerverhältnisse der einzelnen Frequenzteiler (4, 8, 9, 12, 13) und die Frequenz der Referenzspannungsquelle (3) derart gewählt sind, daß von dem im zweiten Phasenregelkreis (2) enthaltenen zweiten spannungsgesteuerten Oszillator (14) eine dem vierfachen Wert der gewünschten Frequenz des Oszillatorsignals (x, y) entsprechende Frequenz geliefert wird, und
**daß** der fünfte Frequenzteiler (13) das Teilerverhältnis 1:4 besitzt.

6. Frequenzsynthesizer nach Anspruch 5,
**dadurch gekennzeichnet,**
**daß** der fünfte Frequenzteiler (13) durch einen Johnson-Zähler realisiert ist, der zwei zueinander um 90° phasenversetzte Oszillatorsignale (x, y) ausgibt.

7. Frequenzsynthesizer nach einem der Ansprüche 1 bis 6,
**dadurch gekennzeichnet,**
**daß** das Teilerverhältnis des ersten bis vierten Frequenzteilers (8, 12, 4, 9) der beiden Phasenregelkreise (1, 2) programmierbar ist.

8. Frequenzsynthesizer nach einem der Ansprüche 1 bis 7,
**dadurch gekennzeichnet,**
**daß** der zweite Phasenregelkreis (2) zwei zweite spannungsgesteuerte Oszillatoren (14) mit unterschiedlichen Frequenzbereichen aufweist, zwischen denen abhängig von der gewünschten Frequenz des Oszillatorsignals (x, y) umgeschaltet werden kann.

9. Frequenzsynthesizer nach einem der Ansprüche 1 bis 8,
**dadurch gekennzeichnet,**
**daß** der in dem zweiten Phasenregelkreis (2) enthaltene zweite Frequenzteiler (9) und vierte Frequenzteiler (12) jeweils durch Kombination eines Teilers (18, 27) mit einem festen Teilerverhältnis und eines Teilers (19, 28) mit einem programmierbaren Teilerverhältnis gebildet ist.

10. Verwendung eines Frequenzsynthesizers nach einem der vorhergehenden Ansprüche als Mischoszillator zur Erzeugung eines einem Mischer (25) zuzuführenden Mischoszillatorsignals (x, y) gewünschter Frequenz.

11. Verwendung nach Anspruch 10,
**dadurch gekennzeichnet,**
**daß** der Frequenzsynthesizer als Mischoszillator in einem Homodynempfänger eingesetzt wird, wobei das von dem Frequenzsynthesizer gelieferte Mischoszillatorsignal (x, y) von dem Mischer (25) mit einem Empfangssignal (HFx, HFy) des Homodynempfängers gemischt wird.

12. Verwendung nach Anspruch 11,
**dadurch gekennzeichnet,**
**daß** der Homodynempfänger ein digitaler Homodynempfänger ist, daß der Mischer (25) ein I/Q-Mischer ist, und
**daß** von dem Frequenzsynthesizer dem I/Q-Mischer (25) zueinander um 90° phasenversetzte Mischoszillatorsignale (x, y) zum Mischen mit den Empfangssignalen des Homodynempfängers zugeführt werden, so daß von dem I/Q-Mischer (25) ein I-Komponentensignal und ein Q-Komponentensignal ausgegeben wird.

## Claims

1. Frequency synthesizer for generating an oscillator signal (x, y) of desired frequency,
having a first phase locked loop (1) for generating a signal of specific frequency (F_{VCO1}) from a reference frequency signal (F_{REF}), a second phase locked loop (2), which is connected in cascaded fashion to the first phase locked loop (1), such that the second phase locked loop (2) is fed as a reference frequency the frequency of the signal (F_{VCO1}) generated by the first phase locked loop, and the oscillator signal (x, y) is generated with the desired frequency by the second phase locked loop (2), the first phase locked loop (1) having a reference voltage source (3) for generating the reference frequency signal (F_{REF}), a first phase detector (5), a first voltage-controlled oscillator (7) and a first frequency divider (8), the first phase detector (5) comparing the frequency (F_{REF}) of the reference frequency signal with a frequency supplied by the first frequency divider (8) and, as a function thereof, driving the first voltage-controlled oscillator (7), the second phase locked loop (2) having a second phase detector (10), a second voltage-controlled oscillator (14) and a second frequency divider (12), the second phase detector (10) comparing a frequency (F_{VCO1}), supplied by the first voltage-controlled oscillator (7) of the first phase locked loop (1), with a frequency supplied by the second frequency divider (12) and, as a function thereof, driving the second voltage-controlled oscillator (14), a signal dependent on the output signal of the second voltage-controlled oscillator (14) being fed to the second frequency divider (12) of the second phase locked loop (2) and to the first frequency divider (8) of the first phase locked loop (1), and the frequency (F_{VCO1}) supplied by the first voltage-controlled oscillator (7) being fed via a fourth frequency divider (9) to the second phase detector (10) of the second phase locked loop (2),
**characterized**
**in that** the frequency (F_{VCO2}) supplied by the second voltage-controlled oscillator (14) of the second phase locked loop (2) is fed to the second frequency divider (12) of the second phase locked loop (2) and to the first frequency divider (8) of the first phase locked loop (1) via a fifth frequency divider (13) and the oscillator signal (x, y) is formed by an output signal of the fifth divider (13).

2. Frequency synthesizer according to Claim 1,
**characterized**
**in that** the signal supplied by the reference voltage source (3) is fed to the first phase detector (5) of the first phase locked loop (1) via a third frequency divider (4).

3. Frequency synthesizer according to Claim 2,
**characterized**
**in that** the individual frequency dividers (4, 8, 9, 12, 13) are respectively implemented by counters.

4. Frequency synthesizer according to Claim 2 or 3,
**characterized**
**in that** the frequency of the reference voltage source (3) and the divider ratio (R₁) of the third frequency divider (4) contained in the first phase locked loop (1) are selected as a function of the desired frequency of the oscillator signal (x, y) in such a way that the first phase detector (5) of the first phase locked loop (1) is fed as reference frequency (F_{REF}) the desired step width of the oscillator signal (x, y).

5. Frequency synthesizer according to one of Claims 1 to 4,
**characterized**
**in that** the divider ratios of the individual frequency dividers (4, 8, 9, 12, 13) and the frequency of the reference voltage source (3) are selected in such a way that the second voltage-controlled oscillator (14) contained in the second phase locked loop (2) supplies a frequency corresponding to four times the value of the desired frequency of the oscillator signal (x, y), and in that
the fifth frequency divider (13) has the divider ratio of 1:4.

6. Frequency synthesizer according to Claim 5,
**characterized**
**in that** the fifth frequency divider (13) is implemented by a Johnson counter which outputs two oscillator signals (x, y) mutually offset in phase by 90°.

7. Frequency synthesizer according to one of Claims 1 to 6,
**characterized**
**in that** the divider ratio of the first to fourth frequency dividers (8, 12, 4, 9) of the two phase locked loops (1, 2) is programmable.

8. Frequency synthesizer according to one of Claims 1 to 7,
**characterized**
**in that** the second phase locked loop (2) has two second voltage-controlled oscillators (14) with different frequency ranges, between which it is possible to switch as a function of the desired frequency of the oscillator signal (x, y).

9. Frequency synthesizer according to one of Claims 1 to 8,
**characterized**
**in that** the second frequency divider (9) contained in the second phase locked loop (2) and the fourth frequency divider (12) is formed in each case by combining a divider (18, 27) with a fixed divider ratio and a divider (19, 28) with a programmable divider ratio.

10. Use of a frequency synthesizer according to one of the preceding claims as a mixing oscillator for generating a mixing oscillator signal (x, y) of desired frequency to be fed to a mixer (25).

11. Use according to Claim 10,
**characterized**
**in that** the frequency synthesizer is used as a mixing oscillator in a homodyne receiver, the mixing oscillator signal (x, y) supplied by the frequency synthesizer being mixed by the mixer (25) with a received signal (HFx, HFy) of the homodyne receiver.

12. Use according to Claim 11,
**characterized**
**in that** the homodyne receiver is a digital homodyne receiver,
**in that** the mixer (25) is an I/Q mixer, and
**in that** the frequency synthesizer feeds the I/Q mixer (25) mixing oscillator signals (x, y), mutually offset in phase by 90°, for mixing with the received signals of the homodyne receiver, such that the I/Q mixer (25) outputs an I component signal and a Q component signal.

## Revendications

1. Synthétiseur de fréquence pour la production d'un signal d'oscillateur (x, y) de fréquence souhaitée,
comportant une première boucle à verrouillage de phase (1) pour la production d'un signal d'une certaine fréquence (F_{VCO1}) à partir d'un signal de fréquence de référence (F_{REF}) et une deuxième boucle à verrouillage de phase (2) qui est branchée en cascade avec la première boucle à verrouillage de phase (1) de telle sorte que la deuxième boucle à verrouillage de phase (2) reçoit comme fréquence de référence la fréquence du premier signal (F_{VCO1}) produit par la première boucle à verrouillage de phase et que la deuxième boucle à verrouillage de phase (2) produit le signal d'oscillateur (x, y) ayant la fréquence souhaitée, dans lequel la première boucle à verrouillage de phase (1) comporte une source de tension de référence (3) pour la production du signal de fréquence de référence (F_{REF}), un premier détecteur de phase (5), un premier oscillateur commandé par tension (7) et un premier diviseur de fréquence (8), dans lequel le premier détecteur de phase (5) compare la fréquence (F_{REF}) du signal de fréquence de référence à une fréquence fournie par le premier diviseur de fréquence (8) et commande le premier oscillateur commandé par tension (7) en fonction de cette comparaison, dans lequel la deuxième boucle à verrouillage de phase (2) comporte un deuxième détecteur de phase (10), un deuxième oscillateur commandé par tension (14) et un deuxième diviseur de tension (12), dans lequel le deuxième détecteur de phase (10) compare une fréquence (F_{VCO1}) fournie par le premier oscillateur commandé par tension (7) de la première boucle à verrouillage de phase (1) à une fréquence fournie par le deuxième diviseur de fréquence (12) et commande le deuxième oscillateur commandé par tension (14) en fonction de cette comparaison, dans lequel un signal dépendant du signal de sortie du deuxième oscillateur commandé par tension (14) est envoyé au deuxième diviseur de fréquence (12) de la deuxième boucle à verrouillage de phase (2) et au premier diviseur de fréquence (8) de la première boucle à verrouillage de phase (1), et dans lequel la fréquence (F_{VCO1}) fournie par le premier oscillateur commandé par tension (7) est envoyée par l'intermédiaire d'un quatrième diviseur de fréquence (9) au deuxième détecteur de phase (10) de la deuxième boucle à verrouillage de phase (2),
**caractérisé par le fait que** la fréquence (F_{VCO2}) fournie par le deuxième oscillateur commandé par tension (14) de la deuxième boucle à verrouillage de phase (2) est envoyée au deuxième diviseur de fréquence (12) de la deuxième boucle à verrouillage de phase (2) et au premier diviseur de fréquence (8) de la première boucle à verrouillage de phase (1) par l'intermédiaire d'un cinquième diviseur de fréquence (13) et que le signal d'oscillateur (x, y) est formé par un signal de sortie du cinquième diviseur (13).

2. Synthétiseur de fréquence selon la revendication 1,
**caractérisé par le fait que** le signal foumi par la source de tension de référence (3) est envoyé par l'intermédiaire d'un troisième diviseur de fréquence (4) au premier détecteur de phase (5) de la première boucle à verrouillage de phase (1).

3. Synthétiseur de fréquence selon la revendication 2,
**caractérisé par le fait que** les différents diviseurs de fréquence (4, 8, 9, 12, 13) sont réalisés chacun par un compteur.

4. Synthétiseur de fréquence selon la revendication 2 ou 3,
**caractérisé par le fait que** la fréquence de la source de tension de référence (3) et le rapport de division (R₁ ) du troisième diviseur de fréquence (4) contenu dans la première boucle à verrouillage de phase (1) sont choisis de telle sorte en fonction de la fréquence souhaitée du signal d'oscillateur (x, y) que le premier détecteur de phase (5) de la première boucle à verrouillage de phase (1) reçoit comme fréquence de référence (F_{REF}) le pas souhaité du signal d'oscillateur (x, y).

5. Synthétiseur de fréquence selon l'une des revendications 1 à 4,
**caractérisé par le fait que** les de division des différents diviseurs de fréquence (4, 8, 9, 12, 13) et la fréquence de la source de tension de référence (3) sont choisis de telle sorte que le deuxième oscillateur commandé par tension (14) contenu dans la deuxième boucle à verrouillage de phase (2) fournit une fréquence correspondant au quadruple de la fréquence souhaitée du signal d'oscillateur (x, y), et
que le cinquième diviseur de fréquence (13) a le rapport de division 1/4.

6. Synthétiseur de fréquence selon la revendication 5,
**caractérisé par le fait que** le cinquième diviseur de fréquence (13) est réalisé par un compteur de Johnson qui délivre deux signaux d'oscillateur (x, y) déphasés de 90° l'un par rapport à l'autre.

7. Synthétiseur de fréquence selon l'une des revendications 1 à 6,
**caractérisé par le fait que** le rapport de division des premier, deuxième, troisième et quatrième diviseurs de fréquence (8, 12, 4, 9) des deux boucles à verrouillage de phase (1, 2) est programmable.

8. Synthétiseur de fréquence selon l'une des revendications 1 à 7,
**caractérisé par le fait que** la deuxième boucle à verrouillage de phase (2) comporte deux deuxièmes oscillateurs commandés par tension (14) qui ont des plages fréquentielles différentes et entre lesquels on peut commuter en fonction de la fréquence souhaitée du signal d'oscillateur (x, y).

9. Synthétiseur de fréquence selon l'une des revendications 1 à 8,
**caractérisé par le fait que** le deuxième (9) et le quatrième (12) diviseur de fréquence qui sont contenus dans la deuxième boucle à verrouillage de phase (2) sont formés chacun par la combinaison d'un diviseur (18, 27) ayant un rapport de division constant et d'un diviseur (19, 28) ayant un rapport de division programmable.

10. Utilisation d'un synthétiseur de fréquence selon l'une des revendications précédentes comme oscillateur mélangeur pour la production d'un signal d'oscillateur mélangeur (x, y) de fréquence souhaitée à envoyer à un mélangeur (25).

11. Utilisation selon la revendication 10,
**caractérisée par le fait que** le synthétiseur de fréquence est utilisé comme oscillateur mélangeur dans un récepteur homodyne, le signal d'oscillateur mélangeur (x, y) fourni par le synthétiseur de fréquence étant mélangé par le mélangeur (25) à un signal de réception (HFx, HFy) du récepteur homodyne.

12. Utilisation selon la revendication 11,
**caractérisée par le fait que**
le récepteur homodyne est un récepteur homodyne numérique,
le mélangeur (25) est un mélangeur I/Q, et
le synthétiseur de fréquence envoie au mélangeur I/Q (25) des signaux d'oscillateur mélangeur (x, y) déphasés de 90° l'un par rapport à l'autre en vue d'un mélange avec les signaux de réception du récepteur homodyne de telle sorte que le mélangeur I/Q (25) fournit un signal à composante I et un signal à composante Q.
